# EUROPÄISCHE PATENTSCHRIFT

(11) **EP 3 440 976 B1**
(45) Veröffentlichungstag und Bekanntmachung des Hinweises auf die Patenterteilung: **14.10.2020**
(21) Anmeldenummer: 18186775.5
(22) Anmeldetag: 01.08.2018
(51) Int. Cl.: A47L 9/28

(54) **VON EINEM AKKUMULATOR BETRIEBENES HAUSHALTSGERÄT SOWIE VERFAHREN ZUM BETRIEB EINES HAUSHALTSGERÄTES**
ACCUMULATOR OF A HOUSEHOLD APPLIANCE AND METHOD FOR OPERATING A HOUSEHOLD APPLIANCE
APPAREIL ÉLECTROMÉNAGER ENTRAÎNÉ PAR UN ACCUMULATEUR AINSI QUE PROCÉDÉ DE FONCTIONNEMENT D'UN APPAREIL ÉLECTROMÉNAGER

(30) Priorität: 11.08.2017 DE 102017118377
(43) Veröffentlichungstag der Anmeldung: 13.02.2019
(73) Patentinhaber: Vorwerk & Co. Interholding GmbH, 42275 Wuppertal (DE)
(72) Erfinder: Sauerwald, Andres, 46238 Bottrop (DE); Isenberg, Gerhard, 50668 Köln (DE); Hülsmann, Dennis, 58300 Wetter (DE); Spitthöver, Christoph, 42117 Wuppertal (DE)
(74) Vertreter: Müller, Enno

(56) Entgegenhaltungen:
- DE-A1-102005 063 240
- US-A1- 2006 137 133

## Beschreibung

### Gebiet der Technik

Die Erfindung betrifft eine Vorrichtung in Form eines akkumulatorbetriebenen Gerätes, insbesondere Haushaltsgerätes, bspw. Reinigungsgerätes, wie Staubsaugers, mit zumindest zwei elektrischen Systemen, wobei ein erstes elektrisches System eine erste Wicklung eines elektrischen Antriebsmotors ist, und wobei die elektrischen Systeme mittels einer elektronischen Steuereinrichtung leistungsübertragend mit einem ersten und einem zweiten Akkumulator elektrisch verbindbar sind.

Die Erfindung betrifft darüber hinaus ein Verfahren zum Betrieb eines derartigen Gerätes.

### Stand der Technik

Ein Boden- oder Fensterreinigungsgerät mit einem Akkumulator gemäß dem Oberbegriff der Ansprüche 1 und 2 wird in der DE 102005 063 240 beschrieben.

Die DE 10 2015 100 339 A1 beschreibt ein von einem Antriebsmotor angetriebenes Vorsatzgerät eines Staubsaugers.

Aus dem Stand der Technik ist eine Vielzahl unterschiedlicher, im Haushalt verwendeter Geräte bekannt, die ohne eine permanente Energieversorgung durch Anschluss an ein Versorgungsnetz betrieben werden können. Als Energiequelle werden Akkumulatoren verwendet. Um einem derartigen, akkumulatorbetriebenen Gerät eine hohe Betriebsdauer zu verleihen, ist ein Akkumulator mit einer entsprechenden großen Kapazität erforderlich. Überschreitet die Kapazität des Akkumulators einen gewissen Grenzwert, bspw. 100 Wh, so darf der Akkumulator nur in einer entsprechenden Gefahrgutklasse transportiert werden. Dies führt zu Mehrkosten und einem höheren Aufwand.

Die Aufspaltung der zum Betrieb des Gerätes erforderlichen Energie in mehrere Energiespeicher, bspw. mehrere Akkumulatoren, ist mit schaltungstechnischen Problemen verbunden. Eine Parallelschaltung der Akkumulatoren ist oftmals wegen ungleicher Akkuspannung nur mit großem Aufwand möglich. Eine Serienschaltung der Akkumulatoren erhöht die Gesamtspannung und führt zu dem Problem, dass andere Motoren verwendet werden müssen oder bestimmte Leistungsstufen, mit denen der Antriebsmotor betrieben wird, nicht verwirklichbar sind.

### Zusammenfassung der Erfindung

Der Erfindung liegt die Aufgabe zugrunde, Maßnahmen anzugeben, mit denen ein zwei elektrische Systeme aufweisendes akkumulatorbetriebenes Gerät gebrauchsvorteilhaft mit mehreren Akkumulatoren betrieben werden kann.

Gelöst wird die Aufgabe durch die in den Ansprüchen angegebene Erfindung.

Ein erfindungsgemäßes Gerät, bspw. ein Haushaltsgerät, insbesondere Reinigungsgerät ist mit zumindest zwei Akkumulatoren ausgestattet. Mit der Steuereinrichtung kann entweder jedes elektrische System mit einem ihm elektrisch individuell zugeordneten Akkumulator betrieben werden oder mehrere elektrische Systeme werden von einem gemeinsamen Akkumulator betrieben. Hierzu kann eine Schalteinrichtung vorgesehen sein, die Schalter aufweist, mit denen die Pole der Akkumulatoren in geeigneter Weise mit den Polen der elektrischen Systeme verbunden werden können. Die Steuereinrichtung ist bevorzugt so eingerichtet, dass Funktionsparameter des ersten und des zweiten Akkumulators erkannt werden können. Ein Funktionsparameter ist insbesondere ein Wert, der angibt, ob einer der mehreren Akkumulatoren vorhanden ist, die Höhe der Polspannung der Akkumulatoren, insbesondere der Leerlaufspannung, die aktuelle Temperatur des Akkumulators und/oder eine Restkapazität des Akkumulators. Das erfindungsgemäße Gerät besitzt eine Schalteinrichtung mit der jeder der mehreren Akkumulatoren leistungsübertragend mit elektrischen Systemen koppelbar ist. Die elektrischen Systeme sind geräteintegrierte Verbraucher, die gleichzeitig oder getrennt voneinander betrieben werden können. Ein elektrisches System ist eine Wicklung eines Antriebsmotors. Der Antriebsmotor besitzt mehrere Wicklungen, bevorzugt zwei Wicklungen, wobei die einzelnen Wicklungen getrennt voneinander bestrombar sind. Abhängig von den erkannten Funktionsparametern kann die Steuereinrichtung die Schalter der Schalteinrichtung so stellen, dass beide elektrischen Systeme, also bspw. zwei Wicklungen, von nur einem Akkumulator leistungsversorgt werden. Beide Wicklungen werden dann von demselben Akkumulator mit Strom versorgt. In einer alternativen Betriebsstellung der Schalteinrichtung können die Schalter so gestellt werden, dass jedes elektrische System individuell an einen der mehreren Akkumulatoren gekoppelt ist, so dass die beiden elektrischen Systeme unabhängig voneinander jeweils von einem Akkumulator mit Leistung versorgt werden. Sind die beiden Systeme die Wicklungen eines Elektromotors, so werden die Elektromotoren jeweils von einem anderen Ackumulator mit Strom versorgt. Jeder Akkumulator bildet somit eine im Wesentlichen unabhängige Quelle für einen elektrischen Strom und eine elektrische Spannung, wobei eine Spannungsregelung vorgesehen ist zur Regelung einer Versorgungsspannung zum Betrieb eines der elektrischen Systeme. Die Regelung der Versorgungsspannung kann über eine Pulsweitenmodulation erfolgen. Jeder Akkumulator kann individuell eine Spannungsversorgung mit Leistung versorgen. Bei dem Verfahren zum Betrieb des akkumulatorbetriebenen Gerätes werden bspw. mit Hilfe geeigneter Sensoren von einer Steuereinrichtung Funktionsparameter ermittelt, die jeweils einem der mehreren Akkumulatoren zugeordnet sind. Wird bspw. festgestellt, dass zwei Akkumulatoren vorhanden sind, die Akkumulatorspannung bzw. die Restkapazität des Akkumulators eine ausreichende Höhe aufweist oder die Temperatur in einem betriebsbereiten Bereich ist, so wird jedes elektrische System unabhängig vom anderen System von einem Akkumulator bestromt. Sind mehr elektrische Systeme als Akkumulatoren vorhanden, so werden zwei oder mehrere elektrische Systeme auch von einem gemeinsamen Akkumulator versorgt. Wird hingegen ein Funktionsparameter ermittelt, der darauf hindeutet, dass nur ein Akkumulator betriebsfähig ist, bspw. weil er der einzige Akkumulator ist oder weil der andere Akkumulator oder die anderen Akkumulatoren einen nicht betriebsbereiten Betriebszustand besitzen, so wird ein einziger Akkumulator verwendet, um alle elektrischen Systeme mit Leistung zu versorgen. Eventuell kann die Steuereinrichtung hier Vorkehrungen treffen, dass die elektrischen Systeme nur eine reduzierte Leistung erhalten. Handelt es sich bspw. bei dem elektrischen Gerät um einen Haushaltsstaubsauger, der einen Antriebsmotor aufweist, der in verschiedenen Leistungsstufen arbeiten kann, bspw. mit einer verminderten Leistung im "Eco-Modus" oder mit hoher Leistung im "Boost-Modus", so kann das Gerät nur dann in den Boost-Modus gebracht werden, wenn es mit zwei oder mehreren Akkumulatoren arbeitet. In der bevorzugten Ausgestaltung werden dann zumindest zwei voneinander verschiedene Motorwicklungen von zumindest zwei voneinander verschiedenen Akkumulatoren mit Leistung versorgt, wobei jedem Akkumulator bevorzugt eine eigene Betriebsspannungsregelung zugeordnet ist. Ist hingegen nur ein Akkumulator betriebsbereit, so unterbindet die elektronische Steuerung, dass der Antriebsmotor mit höchster Leistung betrieben werden kann. Er kann dann nur mit einer verminderten Leistung betrieben werden. Die erfindungsgemäße Vorrichtung besitzt eine Schalteinrichtung mit zumindest drei Schaltern, wobei die Schalter mechanische Schalter, bevorzugt aber Halbleiterschalter sind. Mit einem ersten und einem zweiten Schalter lassen sich der erste bzw. zweite Akkumulator in den Stromkreis schalten. Dieser Schalter liegt im jeweiligen Versorgungsstromkreis des Akkumulators. Ein dritter Schalter bildet bevorzugt einen Brückenschalter, der dann geöffnet ist, wenn der erste und der zweite Schalter gleichzeitig geschlossen sind, also das Gerät mit zwei Akkumulatoren betrieben wird. Der Brückenschalter ist geschlossen, wenn das Gerät mit nur einem Akkumulator betrieben ist, also bspw. der erste oder der zweite Schalter geöffnet ist. Die drei Schalter bilden somit ein Schaltungssystem, bei dem ein Schalter geöffnet und zwei Schalter geschlossen sind. Es ist vorgesehen, dass das Gerät weitere elektrische Systeme, also elektrische Verbraucher aufweisen kann, bspw. einen zweiten Elektromotor, der bei einem Staubsauger bspw. ein Vorsatzgerät antreibt. Dieser zweite Antriebsmotor kann ebenfalls zwei voneinander getrennte Wicklungen aufweisen, die bei einem Betrieb mit mehreren Akkumulatoren jeweils von einem Ackumulator betrieben werden. Es ist aber auch möglich, dass der zweite Antriebsmotor lediglich eine Wicklung aufweist, die wahlweise von einem der mehreren Akkumulatoren betrieben werden kann. Hierzu ist es bspw. möglich, mit einer Multiplexschaltung abhängig vom Funktionsparameter den zweiten Antriebsmotor mit einer Leistung zu betreiben, die jeweils von einem bevorzugt einzigen Akkumulator geliefert wird, wobei jedoch in zeitlicher Abfolge verschiedene Akkumulatoren die Leistung für den zweiten Antriebsmotor erbringen. Bei dem zeitlichen Multiplexing wird immer nur der Akkumulator für die zusätzliche Last gewählt, der jeweils die höchste Restkapazität bzw. höchste Spannung liefert bzw. der ansonsten den geringsten Strom liefert. Ein anderer Auswahlparameter kann darüber hinaus die Akkumulatortemperatur sein.

### Kurze Beschreibung der Zeichnungen

Ausführungsbeispiele der Erfindung werden nachfolgend anhand beigefügter Zeichnungen erläutert. Es zeigen:
- Fig. 1: schematisch eine Schaltung eines mit zwei Akkumulatoren 4, 5 betreibbares Haushaltsgerät in einem ersten Betriebszustand,
- Fig. 2: das in Figur 1 dargestellte Gerät in einem zweiten Betriebszustand,
- Fig. 3: eine Darstellung gemäß Figur 1 eines zweiten Ausführungsbeispiels in einem ersten Betriebszustand,
- Fig. 4: eine Darstellung gemäß Figur 3 in einem zweiten Betriebszustand und
- Fig. 5: ein Blockschaltbild eines weiteren Ausführungsbeispiels.

### Beschreibung der Ausführungsformen

Bei dem erfindungsgemäßen Gerät handelt es sich um ein Elektrogerät mit einem Elektromotor, bspw. einem Staubsauger mit einem Antriebsmotor 1 für ein Gebläse. Die Leistungsversorgung des Antriebsmotors 1 erfolgt über mehrere Akkumulatoren 4, 5, wobei beim Ausführungsbeispiel lediglich zwei Akkumulatoren 4, 5 dargestellt sind. Durch die Verwendung mehrerer kleiner Akkumulatoren fällt das Gerät in eine andere Gefahrenklasse, als ein Gerät mit einem einzigen Akkumulator größerer Kapazität. Das erfindungsgemäße Gerät ist damit mit geringerem Aufwand zu lagern und zu transportieren.

Darüber hinaus braucht bei einem Defekt nur einer der mehreren Ackumulatoren 4, 5 ausgetauscht zu werden, wobei anstelle eines großen Akkumulators ein kleiner Akkumulator 4, 5 auszutauschen ist.

Die Akkumulatoren 4, 5 bilden eine Akkumulatoranordnung, die über eine elektrische Leitverbindung und Schalter 8, 9, 10 einer Schalteinrichtung 6 mit den Wicklungen 2, 3 des Antriebsmotors 1 verbunden sind. Es ist eine Steuereinrichtung 7 vorgesehen, mit der die Schalter 8, 9, 10 von einem sperrenden in einen leitenden Zustand gebracht werden können. Die Wicklungen 2, 3 sind unabhängig voneinander bestrombar, um den Antriebsmotor 1 drehanzutreiben.

Die Leistungsaufnahme des Antriebsmotors 1 wird über eine Betriebsspannungsversorgung durchgeführt, wobei hierzu eine Pulsweitenmodulation der vom Akkumulator 4, 5 gelieferten Spannung vorgesehen ist. Die Spannungsregelungseinrichtung kann vor den Schaltern 8, 9, also zwischen Akkumulator 4 bzw. 5 und Schalter 8, 9 vorgesehen sein. Die Spannungsregelung kann aber auch unmittelbar vor den Wicklungen 2, 3 angeordnet sein.

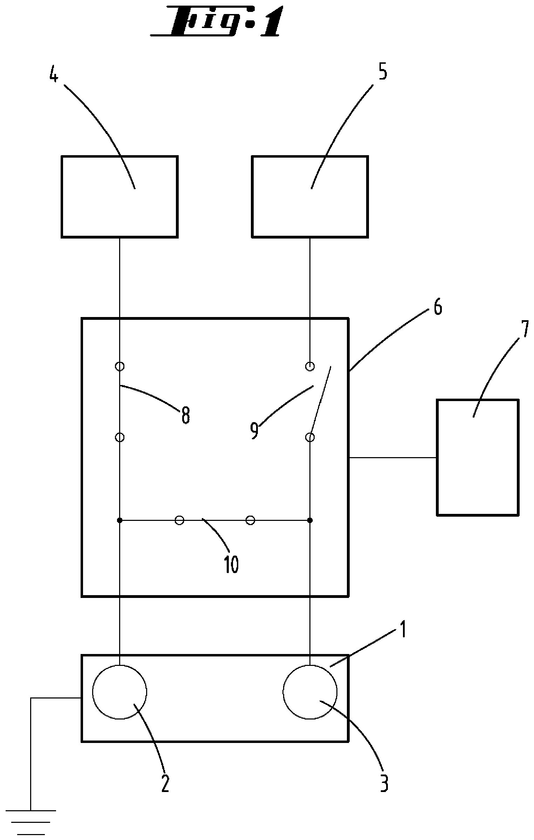

Die Figur 1 zeigt einen Betriebszustand, bei dem lediglich der Akkumulator 4 aktiv ist. Der Akkumulator 5 ist entweder nicht vorhanden oder besitzt aufgrund einer zu geringen Restkapazität keine Funktion. Der Schalter 8, der in den Versorgungsstromkreis des Akkumulators 4 geschaltet ist, ist geschlossen. Der Schalter 9, der sich im Versorgungsstromkreis des Akkumulators 5 befindet, ist geöffnet. Über den geschlossenen Brückenschalter 10 werden die beiden Wicklungen 2, 3 durch vom Akkumulator 4 bereitgestellte Leistung betrieben.

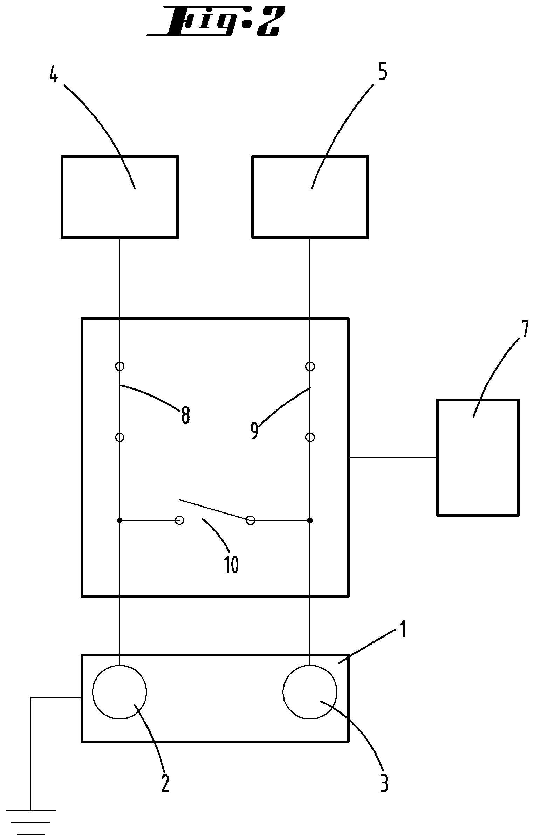

Die Figur 2 zeigt einen abweichenden Betriebszustand, bei dem beide Akkumulatoren 4, 5 sich in einem betriebsfähigen Zustand befinden. Die Stromversorgungsschalter 8, 9 sind geschlossen. Der Brückenschalter 10 ist geöffnet, so dass jede Wicklung 2, 3 von einem ihr zugeordneten Akkumulator 4, 5 mit elektrischer Leistung versorgt wird.

Ein dritter Betriebszustand entspricht analog dem ersten, in der Figur 1 dargestellten Betriebszustand, bei dem der Akkumulator 4 funktionslos ist und der Akkumulator 5 sich in einem betriebsfähigen Zustand befindet. Anders als es in der Figur 1 dargestellt ist, ist dann der Schalter 8 geöffnet und der Schalter 9 geschlossen.

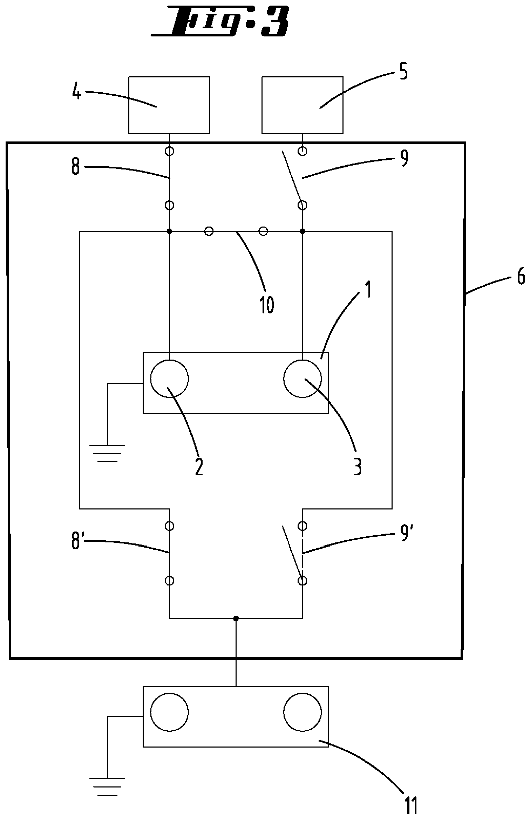

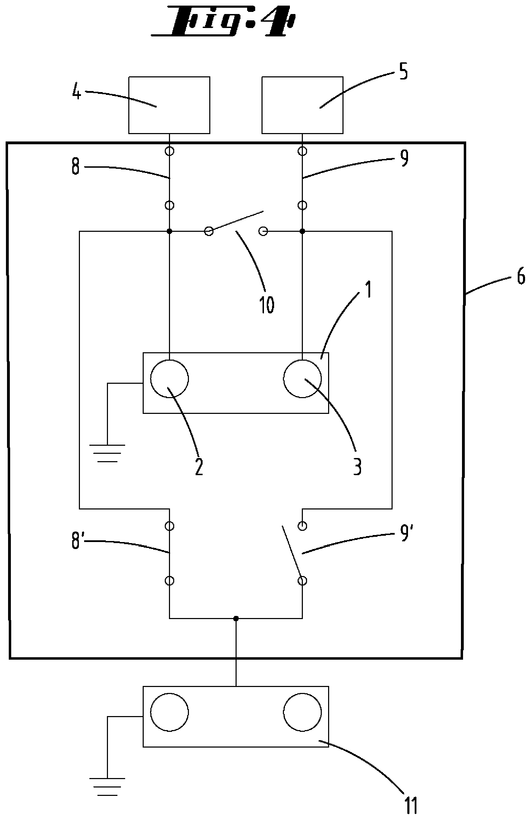

Bei dem in den Figuren 3 und 4 dargestellten Ausführungsbeispiel besitzt das Haushaltsgerät, bspw. der Staubsauger einen zusätzlichen Antriebsmotor 11, mit dem bspw. ein Vorsatzgerät, wie es die DE 10 2015 100 339 A1 beschreibt, betrieben wird.

Bei dem in der Figur 3 dargestellten Betriebszustand ist nur der Akkumulator 4 betriebsfähig. Der Akkumulator 5 ist entweder nicht betriebsfähig oder nicht vorhanden. Der Versorgungsschalter 8 ist geschlossen. Der Versorgungsschalter 9 ist geöffnet. Indem der Brückenschalter 10 geschlossen ist, werden die beiden Wicklungen 2, 3 vom Akkumulator 4 leistungsversorgt. Mit einem Schalter 8', der geschlossen ist, ist der zweite Antriebsmotor 11 mit dem Akkumulator 4 verbunden. Es ist hierbei gleichgültig, ob der Schalter 8', der den zweiten Antriebsmotor 11 mit dem Versorgungsschalter 8 oder ein Schalter 9', der den zweiten Antriebsmotor 11 mit dem Versorgungsschalter 9 verbindet, geschlossen ist.

Bei dem in der Figur 4 dargestellten Betriebszustand sind beide Akkumulatoren 4, 5 funktionsfähig. Hier ist der Brückenschalter 10 geöffnet. Die Wicklungen 2, 3 des Elektromotors 1 werden von verschiedenen Akkumulatoren 4, 5 leistungsversorgt. Ist der Schalter 8' geschlossen und der Schalter 9' geöffnet, so wird der zweite Antriebsmotor 11 vom ersten Akkumulator 4 leistungsversorgt. Ist hingegen der Schalter 8' geöffnet und der Schalter 9' geschlossen, so wird der zweite Antriebsmotor 11 vom Akkumulator 5 leistungsversorgt.

In dem in der Figur 4 dargestellten Betriebszustand ist von den Schaltern 8', 9' jeweils einer geschlossen und einer geöffnet.

Bei dem in den Figuren 1 und 3 dargestellten Betriebszuständen steht für die Leistungsversorgung der beiden Antriebsmotoren 1, 11 lediglich ein Akkumulator zur Verfügung, weshalb hier vorgesehen sein kann, dass die Steuereinrichtung 7 die Antriebsmotoren 1, 11 nur mit einer verminderten maximalen Leistung betreiben kann. In dem Betriebszuständen, die die Figuren 2 und 4 zeigen, ist es allerdings möglich, dass die Steuereinrichtung 7 die Antriebsmotoren 1, 11 auch mit erhöhter Leistung betreiben kann.

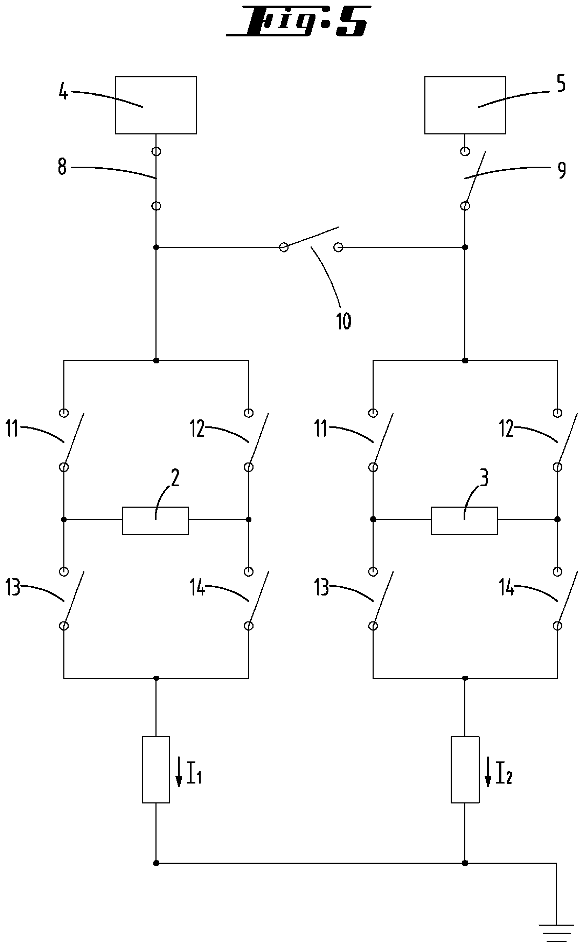

Die Figur 5 zeigt schematisch mit den Schaltern 11, 12, 13, 14 eine Schalteranordnung, wobei die Schalter von der Steuereinrichtung 7 betrieben werden können und insbesondere Halbleiterschalter sind. Die Schalter werden derart betrieben, dass sie über eine Pulsweitenmodulation ein konstantes Spannungsniveau für beide Wicklungen liefern. Unabhängig von der Leerlaufspannung der Akkumulatoren 4, 5 ist durch die Spannungsregelungen gewährleistet, dass die Wicklungen 2, 3 mit identischem Spannungsniveau betrieben werden können.

Es sind nicht dargestellte Sensoren vorgesehen, um die Betriebsströme I1 und I2 zu messen, die durch die Wicklungen 2, 3 hindurchfließen. Ferner sind Sensoren vorgesehen, mit denen die an den Wicklungen 2, 3 anliegenden Betriebsspannungen gemessen werden können. Es sind ferner Sensoren vorgesehen, mit denen die Temperatur der Akkumulatoren 4, 5 oder die Leerlaufspannungen der Akkumulatoren 4, 5 gemessen werden können.

In einer nicht dargestellten Weiterbildung der Erfindung ist vorgesehen, dass das Haushaltsgerät drei oder mehr Akkumulatoren aufweist. Es kann sich bei den Akkumulatoren jeweils um kapazitätsgleiche Akkumulatoren handeln. Die Akkumulatoren können aber auch unterschiedliche Kapazitäten aufweisen. Durch ein zeitliches Multiplexing können die unterschiedlichen Kapazitäten gleichmäßig auf die Gesamtzahl der Verbraucher innerhalb des Haushaltsgerätes aufgeteilt werden.

Es ist insbesondere vorgesehen, dass die Anzahl der Akkumulatoren mindestens so groß ist, wie die Anzahl der Wicklungen des Antriebsmotors.

Bei einem zeitlichen Multiplexing kann bei dem in der Figur 4 dargestellten Betriebszustand in zeitlicher Abfolge die Schalterstellung der Schalter 8', 9' gewechselt werden, so dass in zeitlicher Abfolge der zweite Antriebsmotor 11 sowohl vom Akkumulator 4 als auch vom Akkumulator 5 leistungsversorgt wird.

**Liste der Bezugszeichen**

| | | | |
|---|---|---|---|
| 1 | Antriebsmotor | I1 | Betriebsstrom |
| 2 | erste Wicklung | I2 | Betriebsstrom |
| 3 | zweite Wicklung | | |
| 4 | erster Akkumulator | | |
| 5 | zweiter Akkumulator | | |
| 6 | Schalteinrichtung | | |
| 7 | Steuereinrichtung | | |
| 8 | erster Schalter | | |
| 8' | Schal ter | | |
| 9 | zweiter Schalter | | |
| 9' | Schal ter | | |
| 10 | Brückenschaltung | | |
| 11 | Antriebsmotor | | |
| 12 | Schal ter | | |
| 13 | Schal ter | | |
| 14 | Schal ter | | |

## Patentansprüche

1. Vorrichtung in Form eines akkumulatorbetriebenen Gerätes, insbesondere Haushaltsgerätes, bspw. Reinigungsgerätes, wie Staubsaugers, mit zumindest zwei elektrischen Systemen, wobei ein erstes elektrisches System eine erste Wicklung (2, 3) eines elektrischen Antriebsmotors (1) ist, und wobei die elektrischen Systeme mittels einer elektronischen Steuereinrichtung (7) leistungsübertragend mit einem ersten und einem zweiten Ackumulator (4, 5) elektrisch verbindbar sind, **dadurch gekennzeichnet, dass** das zweite elektrische System eine zweite Wicklung desselben elektrischen Antriebsmotors (1) ist und dass die Steuereinrichtung (7) eingerichtet ist, entweder beide elektrische Systeme mit nur einem Akkumulator (4) zu verbinden oder jedes elektrische System jeweils mit einem Akkumulator (4, 5) zu verbinden.

2. Verfahren zum Betrieb eines akkumulatorbetriebenen Gerätes, insbesondere Haushaltsgerätes, bspw. Reinigungsgerätes, wie Staubsaugers, mit zumindest zwei elektrischen Systemen, wobei ein erstes elektrisches System eine erste Wicklung (2, 3) eines elektrischen Antriebsmotors (1) ist, und wobei die elektrischen Systeme mittels einer elektronischen Steuereinrichtung (7) mit einem ersten und einem zweiten Akkumulator (4, 5) leistungsübertragend elektrisch verbunden werden,, **dadurch gekennzeichnet, dass** das zweite elektrische System eine zweite Wicklung desselben elektrischen Antriebsmotors (1) ist und dass zwei Akkumulatoren (4, 5) verwendet werden, wobei entweder jeweils eine Wicklung von einem der Akkumulatoren (4, 5) mit Leistung versorgt wird oder beide Wicklungen von einem Akkumulator (4, 5) mit Leistung versorgt werden.

3. Vorrichtung nach Anspruch 1 oder Verfahren nach Anspruch 2, **dadurch gekennzeichnet, dass** das zweite System eine zweite Wicklung des Antriebsmotors (1) ist.

4. Vorrichtung oder Verfahren nach einem der vorhergehenden Ansprüche, **dadurch gekennzeichnet, dass** das zweite System ein zweiter Antriebsmotor (11), insbesondere ein Antriebsmotor eines Vorsatzgerätes ist.

5. Vorrichtung oder Verfahren nach einem der vorhergehenden Ansprüche, **dadurch gekennzeichnet, dass** die Steuereinrichtung (8) Funktionsparameter der Akkumulatoren (4, 5) erkennt und abhängig von den Funktionsparametern die elektrischen Verbindungen herstellt.

6. Vorrichtung oder Verfahren nach einem der vorhergehenden Ansprüche, **dadurch gekennzeichnet, dass** eine Schalteranordnung (6) elektrische Schalter (8, 9, 10) aufweist zur wahlweisen Verbindung jeweils eines Ackumulators (4, 5) mit einem elektrischen System oder zur Verbindung mehrerer elektrischer Systeme mit einem gemeinsamen Akkumulator (4, 5).

7. Vorrichtung oder Verfahren nach einem der vorhergehenden Ansprüche, **dadurch gekennzeichnet, dass** die Funktionsparameter eine Angabe über das Vorhandensein eines Akkumulators (4, 5), eine Polspannung des Ackumulators (4, 5), eine Temperatur des Akkumulators (4, 5) und/oder eine Restkapazität des Akkumulators (4, 5) ist.

8. Vorrichtung oder Verfahren nach einem der vorhergehenden Ansprüche, **gekennzeichnet durch** eine insbesondere durch Pulsweitenmodulation gewonnene Versorgungsspannung zum Betrieb des elektrischen Systemes.

9. Vorrichtung oder Verfahren nach einem der vorhergehenden Ansprüche, **dadurch gekennzeichnet, dass** die Schaltung eine im Ausgangsstromkreis des ersten Akkumulators (4) angeordneten ersten Schalters (8), einen im Ausgangsstromkreis des zweiten Akkumulators (5) angeordneten zweiten Schalters (9) und/oder eine die Ausgangsstromkreise der beiden Akkumulatoren (4, 5) miteinander verbindenden Brückenschalter (10) aufweisen.

10. Vorrichtung oder Verfahren nach einem der vorhergehenden Ansprüche, **dadurch gekennzeichnet, dass** ein weiteres elektrisches System, bspw. ein zweiter Antriebsmotor (11) zeitlich aufeinander folgend von verschiedenen Akkumulatoren (4, 5) leistungsversorgt wird.

## Claims

1. A device in the form of an accumulator-operated appliance, in particular household appliance, for example cleaning appliance, such as vacuum cleaner, comprising least two electrical systems, wherein a first electrical system is a first coil (2, 3) of an electrical drive motor (1), and wherein the electrical systems can be electrically connected to a first and a second accumulator (4, 5) by means of an electronic controller (7) so as to transfer power, **characterized in that** the second electrical system is a second winding of the same electrical drive motor (1) and that the controller (7) is set up to either connect both electrical systems to only one accumulator (4) or to connect each electrical system to an accumulator (4, 5) each.

2. A method for operating an accumulator-operated appliance, in particular household appliance, for example cleaning appliance, such as vacuum cleaner, comprising at least two electrical systems, wherein a first electrical system is a first coil (2, 3) of an electrical drive motor (1), and wherein the electrical systems can be electrically connected to a first and a second accumulator (4, 5) by means of an electronic controller (7) so as to transfer power, **characterized in that** the second electrical system is a second winding of the same electrical drive motor (1) and that two accumulators (4, 5) are used, wherein either one winding is in each case supplied with power by one of the accumulators (4, 5), or both windings are supplied with power by one accumulator (4, 5).

3. The device according to claim 1 or method according to claim 2, **characterized in that** the second system is a second winding of the drive motor (1).

4. The device or method according to one of the preceding claims, **characterized in that** the second system is a second drive motor (11), in particular a drive motor of an attachment appliance.

5. The device or method according to one of the preceding claims, **characterized in that** the controller (8) detects functional parameters of the accumulators (4, 5) and establishes the electrical connections as a function of the functional parameters.

6. The device or method according to one of the preceding claims, **characterized in that** a switch arrangement (6) has electrical switches (8, 9, 10) for optionally connecting one accumulator (4, 5) each to an electrical system or for connecting a plurality of electrical systems to a joint accumulator (4, 5).

7. The device or method according to one of the preceding claims, **characterized in that** the functional parameters is information about the presence of an accumulator (4, 5), a pole voltage of the accumulator (4, 5), a temperature of the accumulator (4, 5) and/or a residual capacity of the accumulator (4, 5).

8. The device or method according to one of the preceding claims, **characterized by** a supply voltage, which is obtained in particular by means of pulse width modulation, for operating the electrical system.

9. The device or method according to one of the preceding claims, **characterized in that** the circuit have a first switch (8) arranged in the output circuit of the first accumulator (4), a second switch (9) arranged in the output circuit of the second accumulator (5), and/or a bridge switch (10) connecting the output circuits of the two accumulators (4, 5) to one another.

10. The device or method according to one of the preceding claims, **characterized in that** different accumulators (4, 5) supply power to a further electrical system, for example a second drive motor (11), in chronological order.

## Revendications

1. Dispositif sous la forme d'un appareil fonctionnant sur accumulateurs ou batteries d'accumulateurs, en particulier un appareil ménager, par exemple un appareil de nettoyage tel qu'un aspirateur, avec au moins deux systèmes électriques, dans lequel un premier système électrique est un premier enroulement (2, 3) d'un moteur d'entraînement électrique (1), et dans lequel les systèmes électriques peuvent être reliés en transmission d'énergie à un premier et à un deuxième accumulateur ou batterie d'accumulateurs (4, 5) au moyen d'un dispositif de commande électronique (7), **caractérisé en ce que** le deuxième système électrique est un deuxième enroulement du même moteur d'entraînement électrique (1) et que le dispositif de commande (7) est configuré pour soit relier les deux systèmes électriques à un seul accumulateur ou batterie d'accumulateurs (4), soit pour relier chaque système électrique à un accumulateur ou batterie d'accumulateurs respective (4, 5).

2. Procédé pour faire fonctionner un appareil fonctionnant sur accumulateurs ou batteries d'accumulateurs, en particulier un appareil ménager, par exemple un appareil de nettoyage tel qu'un aspirateur, avec au moins deux systèmes électriques, dans lequel un premier système électrique est un premier enroulement (2, 3) d'un moteur d'entraînement électrique (1), et dans lequel les systèmes électriques peuvent être reliés en transmission d'énergie à un premier et à un deuxième accumulateur ou batteries d'accumulateurs (4, 5) au moyen d'un dispositif de commande électronique (7), **caractérisé en ce que** le deuxième système électrique est un deuxième enroulement du même moteur d'entraînement électrique (1) et **en ce que** deux accumulateurs ou batteries d'accumulateurs (4, 5) sont utilisés, dans lequel soit chaque enroulement est alimenté en énergie par l'un des accumulateurs ou batteries d'accumulateurs (4, 5), soit les deux enroulements sont alimentés en énergie par un accumulateur ou batterie d'accumulateurs (4, 5).

3. Dispositif selon la revendication 1 ou procédé selon la revendication 2, **caractérisé en ce que** le deuxième système est un deuxième enroulement du moteur d'entraînement (1).

4. Dispositif ou procédé selon l'une des revendications précédentes, **caractérisé en ce que** le deuxième système est un deuxième moteur d'entraînement (11), en particulier un moteur d'entraînement d'un dispositif auxiliaire.

5. Dispositif ou procédé selon l'une des revendications précédentes, **caractérisé en ce que** le dispositif de commande (8) reconnaît les paramètres fonctionnels des accumulateurs ou batteries d'accumulateurs (4, 5) et établit les liaisons électriques en fonction des paramètres fonctionnels.

6. Dispositif ou procédé selon l'une des revendications précédentes, **caractérisé en ce qu'**un agencement d'interrupteurs (6) comporte des interrupteurs électriques (8, 9, 10) pour relier sélectivement chaque accumulateur ou batterie d'accumulateurs (4, 5) à un système électrique ou pour relier plusieurs systèmes électriques à un accumulateur ou batterie d'accumulateurs commune (4, 5).

7. Dispositif ou procédé selon l'une des revendications précédentes, **caractérisé en ce que** les paramètres fonctionnels sont une indication de la présence d'un accumulateur ou batterie d'accumulateurs (4, 5), une tension polaire de l'accumulateur ou batterie d'accumulateurs (4, 5), une température de l'accumulateur ou batterie d'accumulateurs (4, 5) et/ou une capacité résiduelle de l'accumulateur ou batterie d'accumulateurs (4, 5).

8. Dispositif ou procédé selon l'une des revendications précédentes, **caractérisé par** une tension d'alimentation pour le fonctionnement du système électrique qui est obtenue en particulier par modulation de largeur d'impulsion.

9. Dispositif ou procédé selon l'une des revendications précédentes, **caractérisé en ce que** le circuit comprend un premier interrupteur (8) agencé dans le circuit de sortie du premier accumulateur ou batterie d'accumulateurs (4), un deuxième interrupteur (9) agencé dans le circuit de sortie du deuxième accumulateur ou batterie d'accumulateurs (5) et/ou un interrupteur de pontage (10) reliant les circuits de sortie des deux accumulateurs ou batteries d'accumulateurs (4, 5) entre eux.

10. Dispositif ou procédé selon l'une des revendications précédentes, **caractérisé en ce qu'**un système électrique additionnel, par exemple un deuxième moteur d'entraînement (11), est alimenté en énergie successivement dans le temps à partir de différents accumulateurs ou batteries d'accumulateurs (4, 5).
